# EUROPÄISCHE PATENTSCHRIFT

(11) **EP 4 088 311 B1**
(45) Veröffentlichungstag und Bekanntmachung des Hinweises auf die Patenterteilung: **10.09.2025**
(21) Anmeldenummer: 20839246.4
(22) Anmeldetag: 16.12.2020
(51) Int. Cl.: F16M 11/38, H01L 21/677, C23C 30/00, C23C 16/27, B66F 7/06, B66F 3/12, F16M 11/18, F16M 11/42, F16M 11/04, F16M 11/24, C23C 16/44, C23C 16/458, H01L 21/687, H01J 37/32

(54) **SUBSTRATAUFNAHME FÜR PROZESSKAMMERN**
SUBSTRATE SUPPORT FOR PROCESSING CHAMBERS
SUPPORT DE SUBSTRAT POUR CHAMBRES DE PROCÉDÉ

(30) Priorität: 07.01.2020 DE 102020100171
(43) Veröffentlichungstag der Anmeldung: 16.11.2022
(73) Patentinhaber: CemeCon AG, 52146 Würselen (DE)
(72) Erfinder: MAY, Walter, 52078 Aachen (DE)
(74) Vertreter: Kalkoff & Partner Patentanwälte mbB
(86) Internationale Anmeldenummer: PCT/EP2020/086351
(87) Internationale Veröffentlichungsnummer: WO 2021/139977

(56) Entgegenhaltungen:
- WO-A1-2020/001718
- CN-A- 108 622 817
- CN-A- 109 019 409
- CN-U- 202 358 880
- DE-A1- 10 156 615
- US-A- 4 744 712
- US-A- 4 981 215
- US-A1- 2011 076 118

## Beschreibung

Die Erfindung betrifft eine Beschichtungsanlage mit einer Haltevorrichtung zum Halten des Werkstücks in einer Prozesskammer sowie ein Verfahren zum Beschichten eines Werkstücks.

Haltevorrichtungen für Werkstücke dienen dazu, Werkstücke so aufzunehmen, dass sie in einer bestimmten Position in einer Prozesskammer gehalten werden. Beispielsweise können so Werkstücke in Beschichtungsanlagen, wie beispielsweise CVD- oder PVD-Anlagen, gehalten werden, um einem Verfahren zum Beschichten ausgesetzt zu werden.

Vorrichtungen zum Halten von Werkstücken sind in vielfältiger Ausgestaltung aus dem Stand der Technik bekannt.

DE 10156 615 B4 offenbart einen Substrathaltertisch, welcher eine Platte mit einem Scherengestänge umfasst. Der Substrathaltertisch kann in verschiedene Richtungen verschoben oder rotiert werden.

Die US 4744712A betrifft ein Herstellungsverfahren für Halbleiter mit Mitteln zur Positionierung von Wafern in einem Diffusionsrohr.

Die US 2011/076118 A1 offenbart ein Mehrkammer-Substratverarbeitungssystem, das für die Herstellung von Dünnschichttransistoren (TFT), organischen Leuchtdioden (OLEDS) und Solarzellen auf flachen Medien geeignet ist. Das System umfasst mehrere Verarbeitungskammern und Ladeschleusenkammern, die um eine zentrale Transferkammer angeordnet sind. Innerhalb der Transferkammer ist ein Transferroboter positioniert.

Es kann als Aufgabe angesehen werden, eine Beschichtungsanlage und ein Verfahren zum Beschichten eines Werkstücks bereitzustellen, bei denen durch eine Haltevorrichtung für Werkstücke eine präzise Höhenverstellbarkeit bei fester und stabiler Lagerung ermöglicht wird.

Die Erfindung löst die Aufgabe durch eine Beschichtungsanlage gemäß Anspruch 1 und ein Verfahren gemäß Anspruch 13. Vorteilhafte Weiterbildungen der Erfindung sind in den jeweils abhängigen Ansprüchen angegeben.

Die erfindungsgemäße Beschichtungsanlage umfasst eine Prozesskammer mit zugeordneten Beschichtungsmitteln zur Erzeugung einer Beschichtung auf einem Werkstück, und eine Haltevorrichtung, welche zwischen einer ersten und einer zweiten Stellung verstellbar angeordnet ist, wobei die Haltevorrichtung in der ersten Stellung innerhalb der Prozesskammer und in der zweiten Stellung mindestens teilweise außerhalb der Prozesskammer angeordnet ist.

Dabei ist die Prozesskammer bevorzugt dazu ausgelegt, dicht abschließbar zu sein, um beispielsweise einen Vakuumzustand zu ermöglichen. Die Beschichtungsmittel ermöglichen es beispielsweise, in der Prozesskammer die vorherrschende Gaszusammensetzung, die Temperatur und/oder den Druck zu verändern, um Beschichtungsverfahren zu ermöglichen. Beispielsweise umfassen die Beschichtungsmittel eine Vakuumpumpe, eine oder bevorzugt mehrere Gaszuführungen, Heizvorrichtungen, eine Vorrichtung zum Verdampfen von Materie und/oder eine Vorrichtung zur Ermöglichung von Oberflächenreaktionen an Werkstücken wie zum Beispiel Vorrichtungen zum Zünden von Plasma oder zum Erhitzen der Werkstoffoberflächen auf mehr als 150°C. Unter diesen Voraussetzungen kann eine Beschichtung auf einem Werkstück angebracht werden, beispielsweise um Werkstücke in ihrer Stabilität, Härte oder Langlebigkeit zu verbessern. Dazu können bevorzugt harte und stabile Materialien auf dem Werkstück abgeschieden werden, wie kristalline Materialen und bevorzugt Diamant.

In der ersten Stellung befindet sich die Haltevorrichtung innerhalb der Prozesskammer. Bevorzugt befindet sie sich vollständig und eingeschlossen in der Prozesskammer, so dass sie einer definierten Beschichtungsatmosphäre ausgesetzt ist. Bevorzugt ist die Haltevorrichtung in der ersten Stellung unbewegt, so dass sich von ihr gehaltene Werkstücke möglichst wenig bewegen.

In der zweiten Stellung befindet sich die Haltevorrichtung zumindest teilweise außerhalb der Prozesskammer, so dass sie besonders einfach mit zu beschichtenden Werkstücken bestückt werden kann oder beschichtete Werkstücke entnommen werden können.

Die erfindungsgemäße Beschichtungsanlage umfasst eine Haltevorrichtung zum Halten von Werkstücken mit einer Ablage für die Werkstücke, einem höhenverstellbaren ersten Stützelement und einem höhenverstellbaren zweiten Stützelement für die Ablage, wobei die Stützelemente jeweils zumindest ein erstes und ein zweites Schenkelelement umfassen, wobei das jeweils erste und das jeweils zweite Schenkelelement gegeneinander um eine Schwenkachse schwenkbar gekoppelt sind, und wobei die Schwenkachse des ersten Stützelements unter einem Winkel zu der Schwenkachse des zweiten Stützelements angeordnet ist.

Die Ablage kann verschieden gestaltet sein. Die Ablage kann so ausgebildet sein, dass sie einen Bereich bereitstellt, der ein Werkstück in einer Position haltend aufnehmen kann. Um eine hohe Flexibilität zu gewährleisten, so dass eine Vielzahl verschiedener Werkstücke von der Ablage gehalten werden kann, kann die Ablage bevorzugt im Wesentlichen eben ausgestaltet sein, so dass auf ihr beispielsweise ein werkstückspezifischer Halter mit dem Werkstück positioniert werden kann. Weiter kann die Ablage zusätzlich Halterungen für die werkstückspezifischen Halter aufweisen, zum Beispiel Einkerbungen oder Nuten.

Die Ablage ist auf einem ersten und einem zweiten Stützelement angeordnet. Die Stützelemente sind dazu ausgelegt, die Ablage in einer Position stabil halten zu können. Dabei sind die Stützelemente höhenverstellbar ausgestaltet, um der Ablage eine Änderung ihrer Position in einer Höhenrichtung ermöglichen zu können. Unter der Höhenrichtung ist dabei eine Abstandsrichtung zwischen der Ablage und einer unterhalb angeordneten Begrenzung zu verstehen, wie beispielsweise einem Boden einer Prozesskammer. Im Folgenden wird die unterhalb der Ablage angeordneten Begrenzung ohne Beschränkung auf bestimmte Ausgestaltungen als Standfläche bezeichnet. Üblicherweise ist dabei die Höhenrichtung senkrecht zu der Standfläche gerichtet und bevorzugt ist eine im Wesentlichen ebene Ablage ebenfalls senkrecht zu der Höhenrichtung gerichtet.

Die zwei Stützelemente umfassen jeweils ein erstes und jeweils ein zweites Schenkelelement. Das jeweils erste und zweite Schenkelelement dienen dazu, eine Höhenverstellbarkeit des entsprechenden Stützelements zu ermöglichen. Dazu sind die Schenkelelemente unter einem variablen Schwenkwinkel zueinander angeordnet. Eine Änderung des Schwenkwinkels bewirkt dabei eine Höhenänderung des gesamten Stützelements, welches beide Schenkelelemente umfasst. Dazu können die Schenkelelemente bevorzugt starr ausgebildet sein. Sie sind in dem Bereich der Schwenkachse, beispielsweise in einem gemeinsamen Verbindungsabschnitt, schwenkbar gekoppelt und können sich um die Schwenkachse herum, bevorzugt unabhängig voneinander, bewegen und so den Schwenkwinkel ändern. Die schwenkbare Kopplung ermöglicht dabei eine kontinuierliche Verstellung des Schwenkwinkels und folglich eine kontinuierliche Höhenverstellbarkeit. Die Schwenkachse kann eine Gerade bezeichnen, um die die Schenkelelemente Rotationsbewegungen ausführen. Zudem kann die Schwenkachse als Achselement ausgeführt sein, so dass die Schenkelelemente in ihrem Verbindungsabschnitt das Achselement umschließen.

Das erste und das zweite Stützelement sind so zueinander positioniert, dass die Schwenkachse des ersten Stützelements unter einem Winkel zu der Schwenkachse des zweiten Stützelements angeordnet ist. Die Anordnung unter einem Winkel ermöglicht eine Abstützung der Ablage in mindestens zwei Richtungen. Eine Drehung der Ablage, beispielsweise um die erste Schwenkachse, kann durch das Stützelement mit der zweiten Schwenkachse unterbunden werden. Der Winkel kann dabei ein spitzer oder ein stumpfer Winkel sein. Bevorzugt sind die Schwenkachsen unter einem rechten Winkel zueinander angeordnet, so dass jedes Stützelement Bewegungen, die das jeweils anderen Stützelement zulässt, senkrecht entgegen gerichtet ist.

Die erfindungsgemäße Beschichtungsanlage mit der Haltevorrichtung für Werkstücke ermöglicht besonders sicher, ein Werkstück fest und stabil zu halten. Die Stützelemente unterbinden jeweils Bewegungen der Ablage und somit des Werkstücks in Richtung einiger Freiheitsgrade. Die Anordnung der Schwenkachsen unter einem Winkel erhöht vorteilhaft die Bewegungseindämmung, da so die Bewegungseindämmung durch das erste Stützelement derjenigen durch das zweite Stützelement überlagert wird. Zugleich bleibt die Höhenverstellbarkeit erhalten, so dass ein Werkstück beispielsweise in einer Beschichtungsanlage innerhalb einer Prozesskammer für einen Beschichtungsverfahren entsprechend positioniert werden kann. Die Höhe der Ablage kann dann zum Beispiel für unterschiedliche große Werkstücke individuell angepasst werden.

Die Höhenverstellbarkeit des ersten und/oder zweiten Stützelements kann verschieden ausgebildet sein. Gemäß einer vorteilhaften Weiterbildung umfasst das erste und/oder zweite Stützelement ein Stellelement, welches dazu ausgelegt ist, das Stützelement in seiner Höhe zu verändern. Dazu kann das Stellelement beispielsweise eine Bewegung des Stützelements bewirken. Dabei kann das Stellelement auf das gesamte Stützelement einwirken oder auf einen einzelnen Bestandteil, wie zum Beispiel ein Schenkelelement. Bevorzugt kann das Stellelement einen Antrieb umfassen, welcher als Linear- oder Drehantrieb ausgebildet sein kann. Beispielsweise kann ein Drehantrieb eine Kurbel oder ein Motor, und Linearantrieb eine Schubstange oder ein Zugseil und bevorzugt ein Spindeltrieb sein.

Das Stellelement kann beispielsweise zur Höhenverstellung das erste Schenkelelement und das zweite Schenkelelement so gegeneinander oder ineinander verschieben, dass die Gesamthöhe des Stützelements verändert wird. Bei einer bevorzugten Ausführungsform ist das Stellelement dazu ausgelegt, einen Schwenkwinkel zwischen dem ersten und zweiten Schenkelelement zu verändern. Dazu kann das Stellelement beispielsweise mit dem ersten und/oder zweiten Schenkelelement gekoppelt sein, um diese um die Schwenkachse zu verschwenken und so ihre Position relativ zueinander zu verändern.

In einer weiteren vorteilhaften Ausführung ist das Stellelement dazu ausgelegt, die Schwenkachse quer zu einer Höhenrichtung zu verschieben. Die Richtung, welche quer zu der Höhenrichtung gerichtet ist, kann dabei als Stellrichtung verstanden werden und kann bevorzugt horizontal gerichtet sein. Bei der Verschiebung der Schwenkachse bleiben bevorzugt die von der Schwenkachse beabstandeten Enden der Schenkelelemente in Stellrichtung im Wesentlichen unbewegt. Weiter bevorzugt sind die Enden der Schenkelelemente gelenkig mit der Ablage und besonders bevorzugt zudem gelenkig mit der Standfläche verbunden. So kann eine Änderung des Schwenkwinkels ebenfalls zu einer Änderung eines Winkels zwischen dem Schenkelelement und der Ablage und/oder zwischen dem Schenkelelement und der Standfläche führen. Die Ablage kann auf diese Weise ihre Höhe ändern und zugleich ihre Ausrichtung beibehalten, so dass sie beispielsweise parallel zu der Standfläche ausgerichtet bleibt.

In einer bevorzugten Ausführung umfasst das erste und/oder zweite Stützelement mindestens ein Axialfederelement zum Aufbringen einer Kraftwirkung in Richtung seiner Schwenkachse. Das Axialfederelement kann bevorzugt an einem Achselement angebracht sein, welches entlang der Schwenkachse angeordnet ist. Das Axialfederelement kann als eine Torsion-, Biege-, Zug- oder Druckfeder ausgestaltet sein und ist bevorzugt eine Druckfeder. Als Spiralfeder kann das Axialfederelement vorteilhaft um das Achselement herum angeordnet sein. Das Axialfederelement kann bevorzugt zwischen dem Schenkelement und dem Achselement wirkend angeordnet sein, indem es zum einen an dem Schenkelement und zum anderen an einem ersten Arretierelement am Achselement anliegt. Bevorzugt ist das Schenkelelement zudem zwischen dem Axialfederelement und beispielsweise einem zweiten Arretierelement am Achselement eingespannt. So kann das Axialfederelement bevorzugt mit seiner Federkraft auf das Schenkelelement wirken, um durch Vorspannung Spiel zwischen dem Schenkelelement und dem Achselement zu vermindern und mittels zusätzlicher Reibungskräfte den Bewegungen des Schenkelelements Trägheit zu verleihen. Auf diese Weise kann die Stabilität der Ablage verbessert werden. Weiter kann es vorteilhaft sein, dass das Stützelement mehrere Axialfederelemente zum Aufbringen einer Kraftwirkung umfasst. So können beispielsweise mindestens zwei Axialfederelemente in entgegengesetzter Richtung auf das Schenkelelement wirken und dieses einspannen. Durch die entgegensetzten Federwirkungen mehrerer Axialfederelemente kann Spiel, insbesondere in axialer Richtung, in besonders vorteilhafter Weise zwischen dem ersten und/oder zweiten Schenkelelement und dem Achselement vermindert werden.

Bei einer bevorzugten Ausführungsform ist ein Konuselement um die Schwenkachse herum angeordnet, wobei das Axialfederelement auf das Konuselement wirkt. Das Konuselement ist bevorzugt zwischen dem Axialfederelement und dem Schenkelelement angeordnet, so dass zum einen das Axialfederelement in axialer Richtung auf das Konuselement wirkt und zum anderen das Konuselement das Schenkelelement und das Achselement zueinander zentriert. Dabei kann das Axialfederelement in axialer Richtung neben dem Konuselement auf dem Achselement angebracht sein und an dem Konuselement anliegen. Bevorzugt weist das Konuselement eine Arretierkerbe auf, welche ein Ende des Axialfederelements aufnimmt und so eine sichere und zentrierte Positionierung des Axialfederelements an dem Konuselement bewirkt. Das Schenkelelement kann bevorzugt eine konische Bohrung aufweisen, welche das Konuselement zumindest teilweise formschlüssig aufnimmt, so dass das Schenkelelement und das Konuselement möglichst spielfrei aneinander anliegen können. Auf diese Weise zentriert das Konuselement die Kraftwirkung des Axialfederelements auf das Schenkelelement, so dass Spiel zwischen dem Schenkelelement und dem Achselement in radialer und axialer Richtung in besonderem Maße vermindert wird. Besonders bevorzugt sind mindestens zwei Konuselemente zwischen dem Schenkelelement und jeweils einem Axialfederelement angeordnet, so dass die Kegelformen spiegelsymmetrisch einander entgegen gerichtet sind und die Axialfederelemente und Konuselemente von zwei entgegen gerichteten Seiten Kraft auf das Schenkelelement ausüben. Weiter ist es bevorzugt, dass das Konuselement mit enger Passung um das Achselement herum anliegt, so dass Reibung den relativen Bewegungen zwischen Konuselement und Achselement Trägheit verleiht.

Entsprechend einer bevorzugten Weiterbildung umfasst nur das erste Stützelement das Stellelement zur Höhenverstellung der Ablage. Das zweite Stützelement kann bevorzugt den durch das erste Stützelement vorgegebenen Bewegungen folgen. Weiter bevorzugt kann das zweite Stützelement Dämpfungselemente zur Bewegungsdämpfung umfassen, beispielsweise zum Aufbringen von Vorspannung.

Gemäß einer vorteilhaften Weiterbildung ist ein Achselement entlang der Schwenkachse angeordnet, wobei ein Radialfederelement zwischen dem ersten und/oder zweiten Schenkelelement und dem Achselement radial wirkend angeordnet ist. Das Radialfederelement verringert durch Vorspannung Spiel zwischen dem Schenkelelement und dem Achselement in radialer Richtung und erzeugt eine zusätzliche Reibungskraft, die zu einer höheren Trägheit der Bewegung des Schenkelements relativ zum Achselement führt. Zusätzlich verringert das Radialfederelement. Das Radialfederelement kann als eine Torsion-, Biege-, Zug- oder Druckfeder ausgestaltet sein und ist bevorzugt eine Druckfeder. Es kann beispielsweise zwischen dem ersten und/oder zweiten Schenkelelement und dem Achselement angebracht sein. Bevorzugt ist das Radialfederelement teilweise oder bevorzugt vollständig in einer Bohrung im Schenkelelement angeordnet. Besonders bevorzugt ist zwischen dem ersten Schenkelement und dem Achselement und zwischen dem zweiten Schenkelelement und dem Achselement jeweils ein Radialfederelement angebracht, so dass zusätzlich Spiel in radialer Richtung für das gesamte Stützelement vermieden werden kann.

Bei einem vorteilhaften Ausführungsbeispiel ist das erste Schenkelelement gabelförmig mit einem ersten und einem zweiten Gabelarm ausgestaltet, wobei das zweite Schenkelelement zwischen dem ersten und dem zweiten Gabelarm eingreifend mit dem ersten Schenkelelement gekoppelt ist. Das erste Schenkelelement kann beispielsweise einen Hauptkörper umfassen, welcher sich an zumindest einer Seite in mindestens zwei Gabelarme fortsetzt. Bevorzugt weisen die Gabelarme jeweils eine Bohrung auf, wobei die Bohrungen fluchtend zueinander und um das Achselement angeordnet sind. Dabei sind die Gabelarme in axialer Richtung voneinander beabstandet, so dass sie dem zweiten Schenkelelement Platz bieten, zwischen ihnen einzugreifen. Bevorzugt umfasst das zweite Schenkelelement ebenfalls eine Bohrung, die fluchtend zu den Bohrungen in den Gabelarmen und um das Achselement angeordnet ist, so dass das erste und das zweite Schenkelelement über das Achselement schwenkbar miteinander gekoppelt sind. Dabei kann das zweite Schenkelelement einen Fortsatz aufweisen, welcher so ausgestaltet ist, dass er zwischen den Gabelarmen angeordnet werden kann. Dazu kann die Breite des Fortsatzes beispielsweise an den Abstand zwischen den Gabelarmen angepasst sein, so dass die Breite bevorzugt mindestens 95% des Abstandes beträgt und besonders bevorzugt mindestens 98%, wodurch Spiel zwischen den Gabelarmen und dem zweiten Schenkelelement minimiert wird. Die Gabelarme bieten beispielsweise den Vorteil, dass eine Schrägstellung des Schenkelelements entlang der axialen Richtung des Achselements vermindert wird, da die zwei zueinander unbeweglichen Gabelarme an zwei beabstandeten Positionen für eine Abstützung sorgen.

Im besonderen Maße ist es bevorzugt, dass das erste und zweite Schenkelelement die gleiche Form aufweisen, so dass beide Schenkelelemente zwei Gabelarme und einen Fortsatz umfassen, welcher in axialer Richtung von den Gabelarmen beabstandet an dem jeweiligen Schenkelelement angeordnet ist. Auf diese Weise kann der Fortsatz des zweiten Schenkelelements zwischen den Gabelarmen des ersten Schenkelelements, und der Fortsatz des ersten Schenkelelements zwischen den Gabelarmen des zweiten Schenkelelements eingreifend angeordnet sein. Dabei kann das Achselement in den Bohrungen der Fortsätze und der Gabelarme beider Schenkelelemente zugleich angeordnet sein, so dass das erste und das zweite Schenkelelement an zwei voneinander beabstandeten Positionen schwenkbar gekoppelt sind.

Bei einer vorteilhaften Weiterbildung ist die Ablage mindestens teilweise in einer Seitenrichtung quer zur Höhenrichtung seitenverstellbar. Dazu kann die Ablage bevorzugt in Abschnitte unterteilt sein, welche zumindest teilweise seitenverstellbar sind. Zum Beispiel kann mindestens ein Abschnitt ortsfest an den Stützelementen angebracht sein und ein weiterer Abschnitt kann seitenverstellbar ausgebildet sein. Der seitenverstellbare Abschnitt kann beweglich mit dem ersten und/oder zweiten Stützelement oder mit dem ortsfesten Abschnitt verbunden sein. Dazu kann der seitenverstellbare Abschnitt beispielsweise auf Schienen verschiebbar oder auf Rollen gelagert sein. Bevorzugt ist der seitenverstellbare Abschnitt auf einer exzentrisch gelagerten Rolle angebracht, welche in einer Aussparung eingreifend angeordnet ist, so dass sie innerhalb der Aussparung in die Seitenrichtung rollend den seitenverstellbaren Abschnitt linear mitbewegen kann. Bevorzugt ist an der Ablage ein Betätigungselement angebracht, welches dazu ausgelegt ist, den seitenverstellbaren Abschnitt zu verstellen. Zum Beispiel kann das Betätigungselement ein Schieber sein, der den seitenverstellbaren Abschnitt auf Schienen anschiebt. Weiter kann das Betätigungselement beispielsweise eine Kurbel oder ein Drehknopf sein, um die Rollen oder die exzentrisch gelagerte Rolle in Bewegung zu versetzten. Die Ablage kann mehrere seitenverstellbare Abschnitte aufweisen, welche sich unabhängig voneinander bewegen lassen. Die Ablage kann dabei in eine oder in mehrere Richtungen quer zur Höhenrichtung seitenverstellbar sein, so dass die Ablage beispielsweise in einer Prozesskammer eine individuell anpassbare Positionierung von Werkstücken ermöglichen kann.

Gemäß einer bevorzugten Ausführungsform bestehen mindestens das erste und das zweite Schenkelement des ersten und/oder zweiten Stützelements aus Graphit. Die Schenkelelemente können aus mehreren aus Graphit bestehenden Abschnitten zusammengesetzt, oder bevorzugt einstückig gebildet sein. Graphit als Material für die Schenkelelemente wirkt sich durch seinen niedrigen Reibungskoeffizienten besonders positiv auf die Fähigkeit aus, dass sich die eng aneinander liegenden Schenkelelemente gleitend bewegen können, wobei beispielsweise die Notwendigkeit eine Schmierung entfällt. Auch für weitere Bauteile der Haltevorrichtung, die sich aneinander anliegend relativ zueinander bewegen, ist der niedrige Reibungskoeffizient von Graphit vorteilhaft. Beispielsweise kann, wenn zwei Bauteile sich aneinander anliegend relativ zueinander bewegen, eines aus Graphit und eines aus einem anderen Material wie zum Beispiel Edelstahl bestehen. Besonders bevorzugt bestehen beide Bauteile aus Graphit. So kann neben den Schenkelelementen die Ablage, an der die Stützelemente schwenkbar angebracht sein können und welche eine seitenverstellbare Beweglichkeit aufweisen kann, aus Graphit bestehen. Ebenso kann die Standfläche, schwenkbar mit den Stützelementen verbunden, aus Graphit bestehen. Auf diese Weise verbessert die Oberflächenbeschaffenheit von Graphit die Schwenkbarkeit der Stützelemente in vorteilhafter Weise.

Die aus Graphit gefertigten Bauteile können beispielsweise aus Graphitpulver in ihre Form gepresst werden. Bevorzugt werden sie aus Graphitplatten einstückig gefertigt, zum Beispiel mittels Fräsen.

Weiter bietet Graphit den Vorteil, seine Form aufgrund seines geringen Ausdehnungskoeffizienten unter Temperaturgefällen und unter Temperaturschwankungen nur sehr gering zu ändern. Die Haltevorrichtung kann bevorzugt in einer Prozesskammer für Beschichtungsverfahren, insbesondere für plasmaunterstützte Beschichtungsverfahren unter Temperaturen im Hochtemperaturbereich, eingesetzt werden. Unter Hochtemperaturbereich ist ein Temperaturbereich zu verstehen mit Temperaturen über 300°C, bevorzugt über 400°C. Dabei können gleichmäßige Temperaturen in der gesamten Prozesskammer vorherrschen, bevorzugt besteht ein Temperaturgefälle zwischen einer unmittelbaren Umgebung des Werkstücks und beispielsweise dem Boden der Prozesskammer. Das Temperaturgefälle kann dabei beispielsweise zwischen einer Temperatur aus dem Hochtemperaturbereich und Raumtemperatur bestehen, welchem die Haltevorrichtung ausgesetzt ist. Ebenso kann die Haltevorrichtung einer Vielzahl von großen Temperaturschwankungen ausgesetzt sein, wenn diese beispielsweise für eine Vielzahl von Beschichtungsprozessen eingesetzt wird, welche bei Hochtemperaturen durchgeführt werden. Wird die Temperatur innerhalb der Prozesskammer zwischen zwei Beschichtungsprozessen gesenkt und/oder wird die Haltevorrichtung aus der Prozesskammer entnommen, so ist die Haltevorrichtung einer großen Temperaturschwankung ausgesetzt.

Die Eigenschaft von Graphit, einen geringen Ausdehnungskoeffizienten zu besitzen, bietet demnach den Vorteil, dass sich die aus Graphit bestehenden Bauteile, wie zum Beispiel die Schenkelelemente, unter Temperaturgefällen und Temperaturschwankungen nur im geringen Maße verziehen, wodurch die Bauteile, beispielsweise bei enger Passung, weder Druck aufeinander ausüben noch Spiel zueinander entstehen lassen. Eingesetzt für eine Vielzahl von Beschichtungsverfahren wirken sich sowohl das geringe Verziehen als auch die geringen Reibungseffekte vorteilhaft auf die Haltevorrichtung aus, da das Risiko niedrig gehalten wird, dass Bewegungen der Bauteile durch Fressen eingeschränkt werden. Somit kann Graphit als Material vorteilhaft für die Lebensdauer der Haltevorrichtung sein, da die Formgebung der Haltevorrichtung auch bei einer hohen Zykluszahl der Beschichtungsprozesse nur im geringen Maße beeinträchtigt wird.

Eine im Wesentlichen aus Graphit bestehende Haltevorrichtung ist insbesondere für kohlenstoffbasierte Abscheidungsprozesse vorteilhaft, beispielsweise für heißdrahtaktivierte CVD-Beschichtungsprozesse, da sie sich nur im geringen Maße auf die Atmosphäre in der Prozesskammer auswirkt.

In einer bevorzugten Ausführung umfasst das erste und/oder das zweite Stützelement neben dem ersten und zweiten Schenkelelement ein drittes und viertes Schenkelelement, wobei das dritte und vierte Schenkelelement gegeneinander um eine Schwenkachse schwenkbar gekoppelt sind, und wobei die Schwenkachse des dritten und vierten Schenkelelements parallel und im Abstand zu der Schwenkachse des ersten und zweiten Schenkelelements angeordnet ist. Bevorzugt ist das dritte Schenkelelement wie das erste und das vierte Schenkelelement wie das zweite ausgebildet, besonders bevorzugt sind alle vier Schenkelelemente gleich geformt. Weiter ist es bevorzugt, dass das dritte und vierte Schenkelelement spiegelsymmetrisch zu dem ersten und zweiten Schenkelelement angeordnet sind, wobei die Symmetrieebene parallel zu den Schwenkachsen verläuft. Die Stützelemente können relativ zueinander auf verschiedene Weise angeordnet sein. Sie können beispielsweise nebeneinander angeordnet sein. Bevorzugt bilden ihre Schwenkachsen ein Viereck und besonders bevorzugt ein Rechteck. So kann beispielsweise die Ablage ebenfalls als Rechteck ausgebildet und so auf den Stützelementen positioniert sein, dass die Stützelement im Wesentlichen an den Seiten der Ablage entlang verlaufend positioniert sind.

Gemäß einer bevorzugten Ausführungsform der erfindungsgemäßen Beschichtungsanlage ist zum Verstellen zwischen der ersten und der zweiten Stellung die Haltevorrichtung auf mindestens einer Rolle verschiebbar gelagert, welche aus Graphit gefertigt ist. Die Rolle kann unter oder seitlich an der Haltevorrichtung angebracht sein, beispielsweise kann sie an den Stützelementen angeordnet sein. Bevorzugt ist eine Bodenplatte zwischen den Stützelementen und der Rolle angeordnet. Besonders bevorzugt weist die Bodenplatte die gleiche Form auf wie die Ablage, beispielsweise eine rechteckige Form. Eine Lagerung der Haltevorrichtung auf der Rolle ermöglicht ein einfaches und sicheres Verstellen zwischen der ersten und zweiten Stellung. Zudem ist die Rolle als Verstellsystem einfach und mit wenigen Bauteilen zu realisieren. Eine Fertigung der Rolle aus Graphit bietet die vorangehend beschriebenen Vorteile von Graphit für Bauteile, die an weiteren Bauteilen angebracht sind und sich relativ zu diesen bewegen. Besonders bevorzugt ist die Haltevorrichtung auf mehreren Rollen gelagert, besonders bevorzugt auf vier Rollen, welche beispielsweise an den vier äußeren Ecken einer rechteckigen Bodenplatte angebracht sein können.

Entsprechend einer bevorzugten Weiterbildung der erfindungsgemäßen Beschichtungsanlage umfassen die Beschichtungsmittel Filamente, d.h. Drähte, welche dazu ausgelegt sind, von einem Strom durchflossen zu werden, so dass sie erhitzen. Bevorzugt sind sie dazu ausgelegt, Temperaturen über 150°C zu erreichen, besonders bevorzugt über 1000°C. Befinden sich die Filamente nahe an der Oberfläche eines Werkstücks, so erhitzen sie diese, bevorzugt, um auf diese Weise Oberflächenreaktionen zur chemischen Abscheidung von Schichten, besonders bevorzugt von Diamantschichten, aus der Gasphase einer Feststoffkomponente auf dem Werkstück zu ermöglichen. Weiter sind die Filamente dazu ausgelegt, beispielsweise Wasserstoffgas in freie Radikale aufzuspalten, welche anschließend mit kohlenstoffhaltigem Gas reagieren können, um Kohlenstoff in Diamantform auf dem Werkstück abzuscheiden.

Um ein Erhitzen der Oberfläche des Werkstücks zu ermöglichen und das Wasserstoffgas nahe der Oberfläche zu aktivieren, sind die Filamente bevorzugt so in der Prozesskammer angeordnet, dass in der ersten Stellung die Höhe der Ablage relativ zu den Filamenten einstellbar ist. Dazu sind die Filamente in der Prozesskammer oberhalb der Ablage angebracht, so dass durch eine Höhenverstellung der Ablage die Filamente und die Ablage aufeinander zu oder voneinander wegbewegt werden können, so dass verschieden große Werkstücke auf der Ablage und zugleich nahe zu den Filamenten angeordnet werden können. Bevorzugt sind die Filamente so in der Prozesskammer angebracht, dass sie senkrecht zu der Ablage gerichtet sind. Bevorzugt befinden sich in der Prozesskammer mehrere Filamente, die innerhalb einer Ebene parallel zueinander angebracht sind. Besonders bevorzugt sind zwei Ebenen mit Filamenten parallel zueinander angeordnet. Diese Anbringung der Filamente erweist sich als besonders vorteilhaft zum zweiseitigen Erhitzen von Werkstücken, deren Höhenausdehnung dominiert, da ein Werkstück zum Beispiel zwischen den Ebenen aus Filamenten positioniert werden kann.

Ausführungsbeispiele der Erfindung werden nachstehend mit Bezug auf Zeichnungen näher erläutert. Die Figuren zeigen:
- Fig. 1: eine perspektivische Ansicht eines ersten Ausführungsbeispiels einer Haltevorrichtung,
- Fig. 2: eine Explosionsdarstellung der Haltevorrichtung gemäß Fig. 1,
- Fig. 3: eine perspektivische Ansicht eines Stützelements der Haltevorrichtung gemäß Fig. 1 und 2,
- Fig. 4: eine perspektivische Ansicht eines weiteren Stützelements der Haltevorrichtung gemäß Fig. 1-3,
- Fig. 5: ein Teilschnitt entlang der Schnittlinie A..A' in Fig. 4,
- Fig. 6: eine Schnittdarstellung eines Schenkelelements entlang der Schnittlinie A..A' in Fig. 4,
- Fig. 7, 8: teilweise schematische Darstellungen einer Beschichtungsanlage mit einer Haltevorrichtung gemäß Fig. 1-6 in Front- und Seitenansicht.

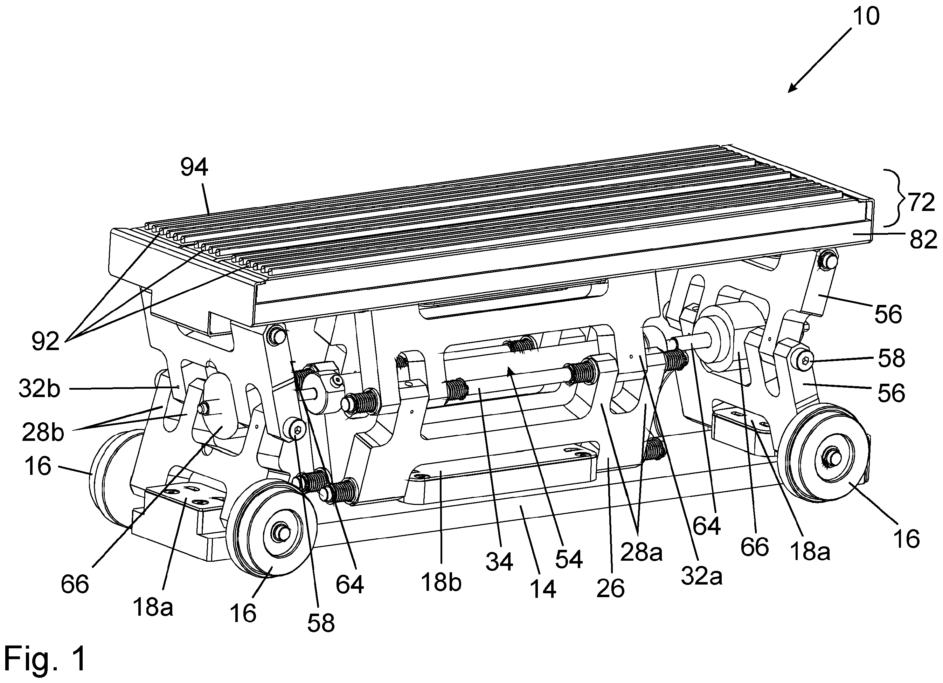

Fig. 1 zeigt ein erstes Ausführungsbeispiel einer Vorrichtung zum Halten von Werkstücken 10, im Folgenden als Haltevorrichtung 10 bezeichnet, mit einer Unterkonstruktion 12, einem ersten und einem zweiten höhenverstellbaren Stützelement 22, 48 und einer Ablage 72.

Auf der Unterkonstruktion 12 sind die Stützelemente 22, 48 befestigt, welche die Ablage 72 stützen.

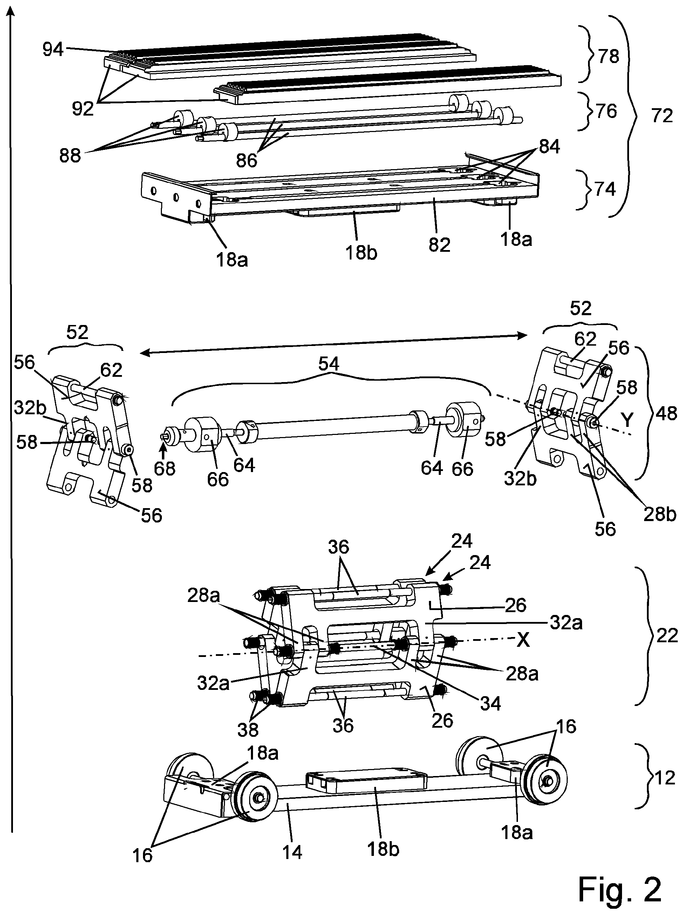

Fig. 2 zeigt die Haltevorrichtung 10 aus Fig. 1, wobei die dargestellten Bauteile für die Explosionsdarstellung in den Pfeilrichtungen verschoben sind.

Die Unterkonstruktion 12 besteht aus einer Bodenplatte 14 und vier Rollen 16. Die Bodenplatte 14 ist eine rechteckige und ebene Graphitplatte mit zwei Längsseiten und zwei kurzen Seiten. An beiden kurzen Seiten und mittig sind auf ihrer Oberseite drei metallische Befestigungsblöcke 18a, 18b zur Montage der Rollen 16 und der Stützelemente 22, 48 montiert. Die vier Rollen 16 sind drehbar und hierfür jeweils paarweise mittels einer Achse verbunden. Jeweils eine Achse ist in einem Befestigungsblock 18a an einer kurzen Seite der Bodenplatte 14 angebracht.

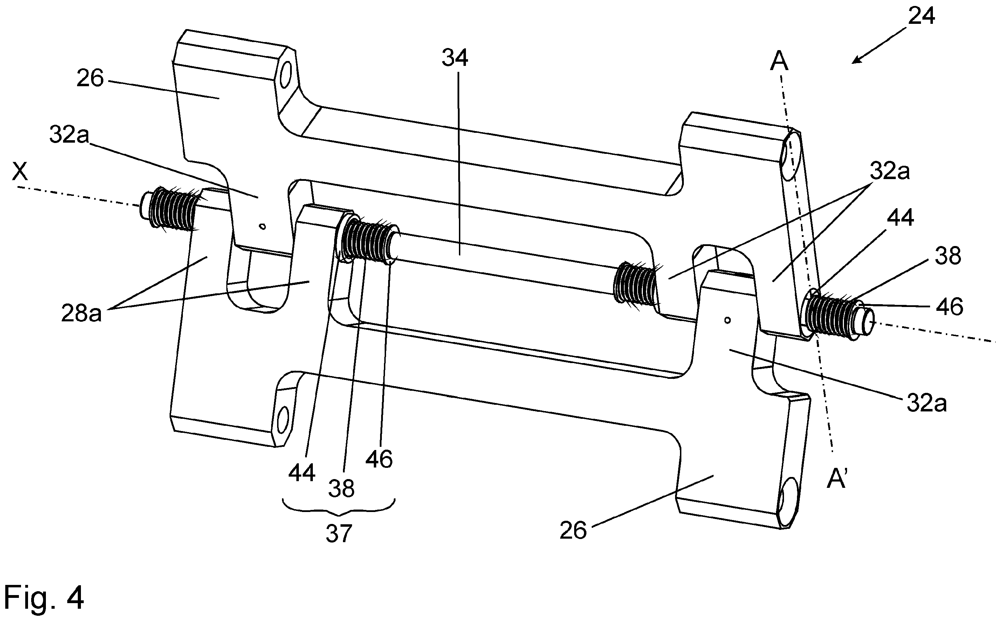

Das erste Stützelement 22 umfasst zwei spiegelsymmetrisch aufgebaute Längsstützeinheiten 24, von denen eine in Fig. 4 gezeigt ist, mit zwei Längsschenkelelementen 26 und einem Achselement 34.

Die Längsschenkelelemente 26 sind jeweils aus einer rechteckigen Graphitplatte ausgeschnitten, so dass sie an ihren Längsseiten Fortsätze aufweisen. Zwei Gabelfortsätze 28a sind eine Gabel bildend dicht beieinander positioniert. Von der Gabel beabstandet ist ein Einzelfortsatz 32a an der gleichen Längsseite angeordnet.

Jeweils zwei Längsschenkelelemente 26 sind über das Achselement 34 gekoppelt, indem jeweils ein Einzelfortsatz 32a zwischen die Gabelfortsätze 28a greift und das Achselement 34 in fluchtenden Bohrungen durch die Fortsätze 28a, 32a beider Längsschenkelelemente 26 hindurch verläuft. Auf diese Weise sind die beiden Längsschenkelelemente 26 um eine Längsschwenkachse X schwenkbar gekoppelt, indem sie über das entlang der Längsschwenkachse X angeordnete Achselement 34 gelenkig miteinander verbunden sind, so dass der zwischen ihnen eingeschlossenen Winkel verändert werden kann.

Zur schwenkbaren Anbringung des ersten Stützelements 22 an der Unterkonstruktion 12 und an der Ablage 72 verlaufen zwei Längsbefestigungsachsen 36 durch die Außenlängsseiten beider Längsstützeinheiten 24.

Sowohl an dem Achselement 34 als auch an den Längsbefestigungsachsen 36 sind Axialspanneinheiten 37 angebracht, für die jeweils ein Konus 44, eine Axialfeder 38 und ein Arretierring 46 zusammenwirken. Die Axialspanneinheiten 37 sind zum einen auf dem Achselement 34 an beiden Außenseiten beider Gabeln angebracht (s. Fig. 4) und zum anderen auf den Längsbefestigungsachsen 36 an den Außenseiten der Längsschenkelelemente 26 (s. Fig. 2). Die Axialspanneinheiten 37 spannen die gelenkigen Verbindungen der Längsschenkelelemente an dem Achselement 34 und an den Längsbefestigungsachsen 36 in axialer Richtung vor.

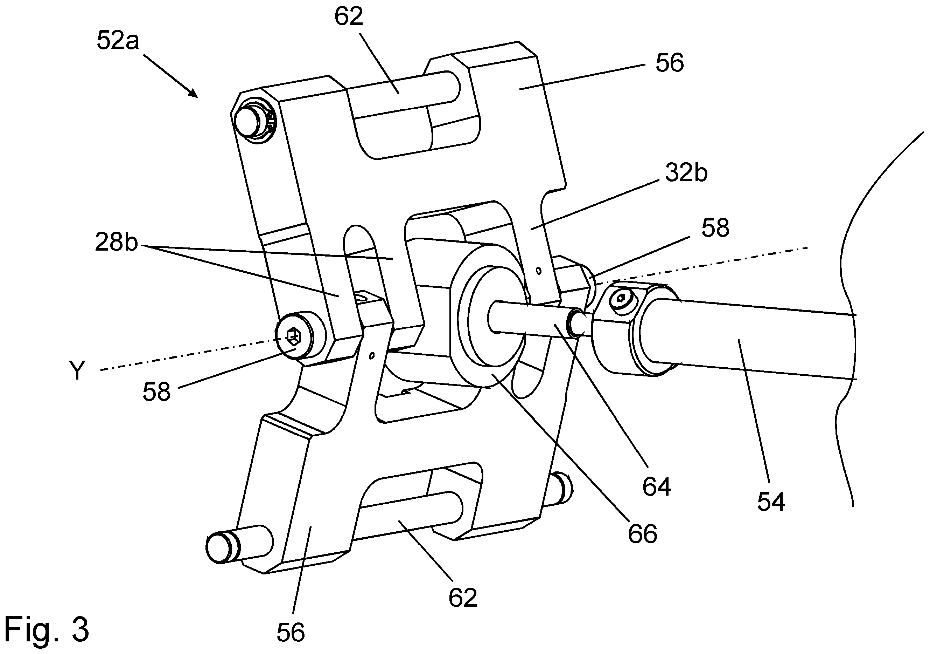

Das zweite Stützelement 48 umfasst zwei spiegelsymmetrisch aufgebaute Querstützeinheiten 52 und ein Stellelement 54. Fig. 3 zeigt dazu eine Querstützeinheit 52 und teilweise das damit verbundene Stellelement 54. Das Stellelement 54 ist dabei symmetrisch ausgebildet und an ihm ist spiegelsymmetrisch die zweite Querstützeinheit 52 angebracht. Die Querstützeinheiten 52 weisen jeweils zwei Querschenkelelemente 56 auf, die gleich und ebenfalls als Graphitplatten geformt sind. An ihren Längsseiten befinden sich analog zu den Längsschenkelelementen 26 jeweils zwei Gabelfortsätze 28b und ein Einzelfortsatz 32b.

Entlang einer Querschwenkachse Y sind zwei Schrauben 58 in Achsrichtung voneinander beabstandet so angebracht, dass über jeweils eine Schraube 58 zwei Gabelfortsätze 28b mit einem Einzelfortsatz 32b schwenkbar gekoppelt sind.

Das Stellelement 54 ist als Spindel ausgebildet und umfasst zu beiden Seiten jeweils ein Spindelgewinde 64, das mit jeweils einer Gewindemutter 66 im Eingriff steht. Zudem befindet sich an einer Seite des Stellelements 54 ein Kopplungselement 68 (s. Fig. 2), um zum Beispiel mit einem Schlüssel die Spindel 54 zu rotieren.

Die Gewindemutter 66 ist mit der Querstützeinheit 52 gekoppelt, indem sie zwischen den zwei Gabeln der Querstützeinheit 52 angeordnet ist und von beiden Seiten mit den Schrauben 58 verschraubt ist. Dabei liegt die Gewindemutter 66 auf der Querschwenkachse Y, so dass sie von dieser mittig durchdrungen wird und die Achse des Stellelements 54 senkrecht zu der Achse Y ausgerichtet ist. Eine der beiden Gewindemuttern 66 weist ein rechtsdrehendes Gewinde und die andere ein linksdrehendes Gewinde auf, so dass ihre Bewegungen bei Rotation des Stellelements 54 entgegen gesetzt sind und sie sich aufeinander zu oder voneinander wegbewegen.

Zur schwenkbaren Anbringung des zweiten Stützelements 48 an der Unterkonstruktion 12 und an der Ablage 72 verlaufen zwei Querbefestigungsachsen 62 durch die Außenlängsseiten beider Querstützeinheiten 24.

Die Ablage 72 umfasst eine Befestigungseinheit 74, eine Betätigungseinheit 76 und eine Ablageeinheit 78. Die Ablageeinheit 78 liegt oben auf der Befestigungseinheit 74 auf und beide schließen die Betätigungseinheit 76 in ihrem Inneren ein.

Die Befestigungseinheit 74 umfasst eine ebene, rechteckige Befestigungsplatte 82, welche aus einer Graphitplatte gefertigt ist. Sie weist drei längliche Aussparungen 84 auf, welche parallel zu ihren Längsseiten verlaufen. An der Unterseite der Befestigungsplatte 82 befinden sich analog zu der Bodenplatte 14 zwei Befestigungsblöcke 18a an den kurzen Seiten und ein Befestigungsblock 18b in der Mitte der Befestigungsplatte 82.

Die Betätigungseinheit 76 weist drei gleiche Exzenterwellen 86 auf, an deren Enden jeweils ein Exzenter 88 angebracht ist. Alle sechs Exzenter 88 sind ebenfalls gleich geformt.

Die Ablageeinheit 78 ist zusammengesetzt aus drei einzelnen, ebenen, rechteckigen Ablageplatten 92, die ebenfalls aus Graphitplatten gefertigt sind und auf ihrer Unterseite Aussparungen in Längsrichtungen aufweisen (nicht gezeigt). Auf allen drei Ablageplatten 92 befinden sich mehrere Stege zur Bildung von Führungsnuten 94 in Längsrichtung.

Die Betätigungseinheit 76 liegt in den Aussparungen der Befestigungseinheit 84 und der Ablageeinheit 78, so dass die Exzenterwellen 86 rotieren und die Exzenter 88 Rotations- und Linearbewegungen vollziehen können. Auf jeweils einer Exzenterwelle 86 mit zwei Exzentern 88 liegt eine Ablageplatte 92 so auf, dass sich die Exzenterwelle 86 und die Exzenter 88 innerhalb der Aussparungen der Ablageplatte 92 befinden. Eine Drehung einer der Exzenterwellen 86 kann so die aufliegende Ablageplatte 92 relativ zu der Befestigungsplatte 82 in Querrichtung verstellen.

Die Unterkonstruktion 12, die beiden Stützelemente 22, 48 und die Ablage 72 sind miteinander über die Längs- und Querbefestigungsachsen 36, 62 verbunden, die in Befestigungsblöcken 18a, 18b drehbar gelagert sind (s. Fig. 1). Für beide Längsstützeinheiten 24 und beide Querstützeinheiten 52 ist dabei jeweils eine Längsbefestigungsachse 36, beziehungsweise Querbefestigungsachse 62, in einem Befestigungsblock 18a, 18b an der Bodenplatte 14 und in einem Befestigungsblock 18a, 18b an der Befestigungsplatte 82 gelenkig angebracht.

Die Ablage 72, die parallel zur der Unterkonstruktion 12 ausgerichtet ist, kann mit Hilfe des zweiten Stützelements 48 höhenverstellt werden. Dazu wird es mittels des Stellelements 54 so in seiner Höhe verändert, dass es den Abstand zwischen der Unterkonstruktion 12 und der Ablage 72 verändert.

Die Höhenverstellbarkeit des zweiten Stützelements 48 ist mittels eines Kniehebelgelenks realisiert. Über die Querschenkelelemente 56 sind drei Achsen gelenkig verbunden, die Querschwenkachse Y, und die beiden Querbefestigungsachsen 62. In der Querschwenkachse Y sind die Querschenkelelemente 56 miteinander und mit dem Stellelement 54 so gekoppelt, dass das Stellelement 54 die Querschwenkachse Y translatorisch quer zur Richtung der Höhenverstellung verschieben und so die Querschenkelelemente 56 in ihrer gelenkigen Verbindung beugen oder strecken kann. So bleiben die Unterkonstruktion 12 und die Ablage 12 bei einer Höhenverstellung gleich ausgerichtet und parallel zueinander.

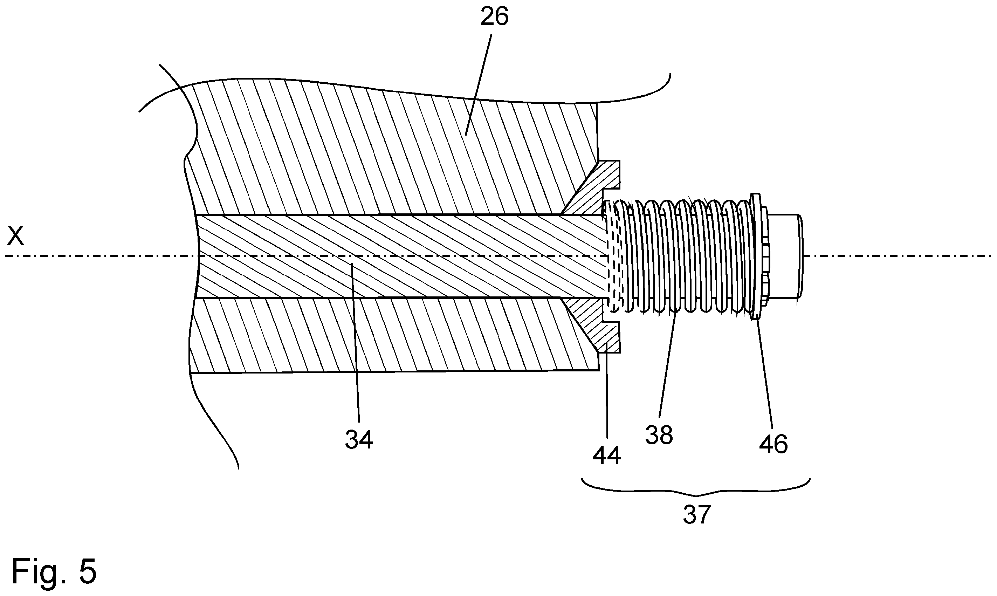

Fig. 5 zeigt einen Ausschnitt eines der beiden Längsschenkelelemente 26 mit der Axialspanneinheit 37. Der Konus 44 weist eine Bohrung auf, die so an das Achselement 34 angepasst ist, dass der Konus 44 mit enger Passung um dieses anliegt. Weiter liegt der Konus 44 mit seinem kegelförmigen Abschnitt formschlüssig in einer ebenfalls kegelförmigen Materialaussparung des Längsschenkelelements 26, so dass er von diesem teilweise eingeschlossen ist. Außerhalb des Längsschenkelelements 26 weist der Konus 44 im Schnitt eine Kerbe auf, in der er die Axialfeder 38 aufnimmt, um dieser Halt und somit eine optimale Kraftübertragung von der Axialfeder 38 auf das Längsschenkelelements 26 zu gewährleisten. Das andere Ende der Axialfeder 38 ist von einem unbeweglichen Arretierring 46 gehalten. Zwischen dem Konus 44 und dem Arretierring 46 ist dabei die Axialfeder 38 so vorgespannt, dass sie in Richtung der Achse X eine Kraft ausübt. Zwei Axialspanneinheiten 37 spannen die Gabel beidseitig ein und zentrieren das Achselement 34 in den Bohrungen des Längsschenkelelements 26 (s. Fig. 4). Auf diese Weise wird Spiel der Längsschenkelelemente 26, insbesondere in Richtung der Achse X, verringert und die Reibung an dem von den beiden Längsschenkelelementen 26 gebildeten Gelenk erhöht, so dass sich die Trägheit der Bewegungen der Längsschenkelelemente 26 erhöht.

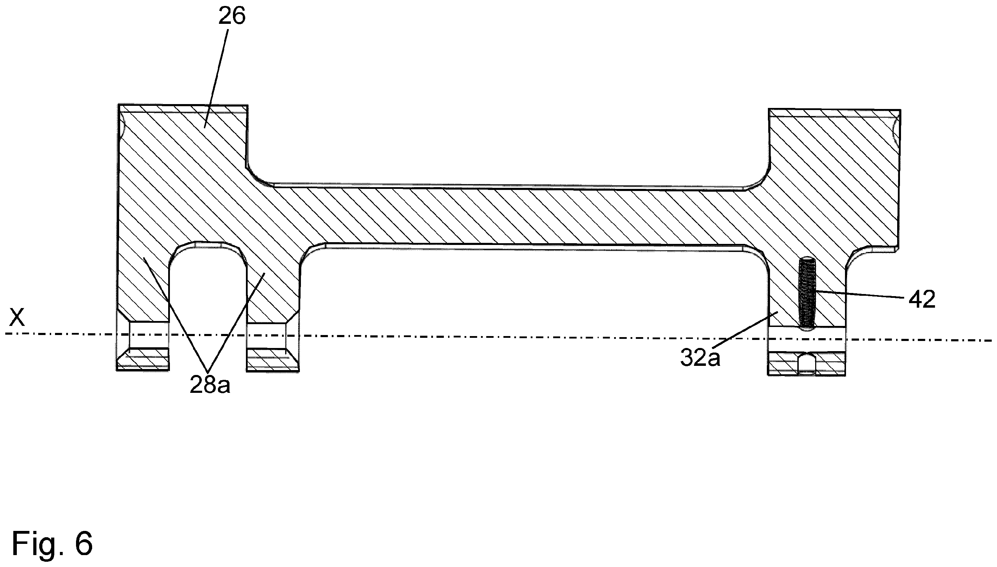

Fig. 6 zeigt die Anordnung einer Radialfeder 42 im Inneren des Längsschenkelelements 26, genauer im Einzelfortsatz 32a. Sie ist in einer Bohrung angebracht, die senkrecht zur Achse X gerichtet ist und wirkt so zwischen dem Längsschenkelelement 26 und dem Achselement 34. Durch ihre Vorspannung mindert sie ebenfalls Spiel und erhöht die Reibung. Für die Längsstützeinheit 24 ist in beiden Längsschenkelelementen 26 eine Radialfeder 42 angebracht, so dass diese aus entgegensetzten Richtungen auf das Achselement 34 wirken.

Auch in den Einzelfortsätzen 32a des zweiten Stützelements 48 sind auf analoge Weise Radialfedern 42 eingebracht (nicht dargestellt).

Das erste Stützelement 22 hat für die Haltevorrichtung 10 keine höhenverstellende, sondern lediglich eine stützende Wirkung entlang der Längsseite der Ablage 72. Das zweite Stützelement 48 hat neben seiner höhenverstellenden zusätzlich eine stützende Wirkung entlang der Querseiten der Ablage 72. So sind die stützenden Wirkungen rechtwinklig zueinander gerichtet und erhöhen die Bandbreite der Richtungen, in denen Spiel verringert wird. Die Beabstandung der Längsstützeinheiten 24 zueinander und der Querstützeinheiten 52 zueinander, und die Dämpfung der Bewegungen des ersten Stützelements 22 führen zu einer stabilen Halterung der Ablage 72 ohne Wackeln.

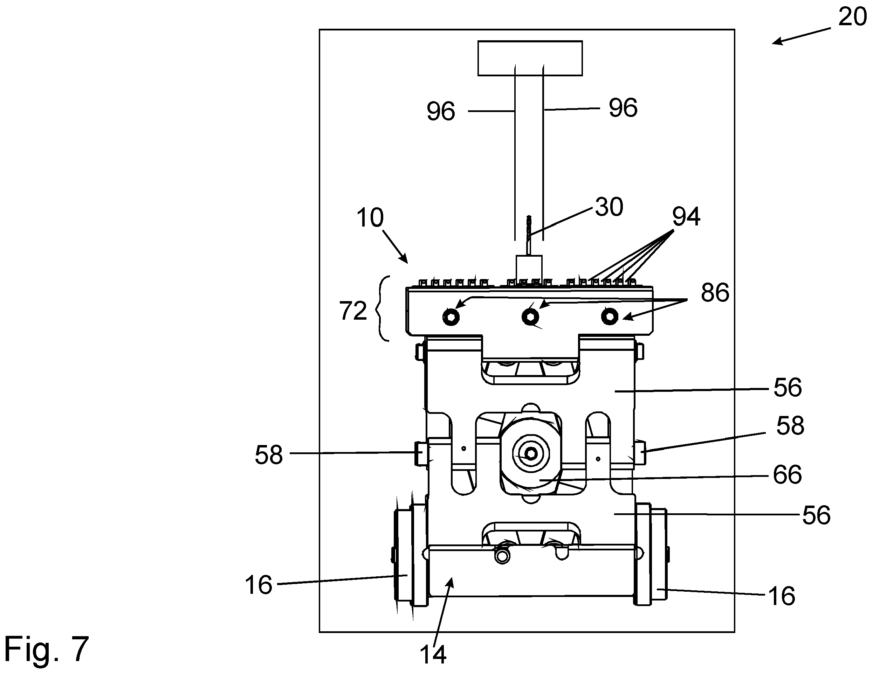

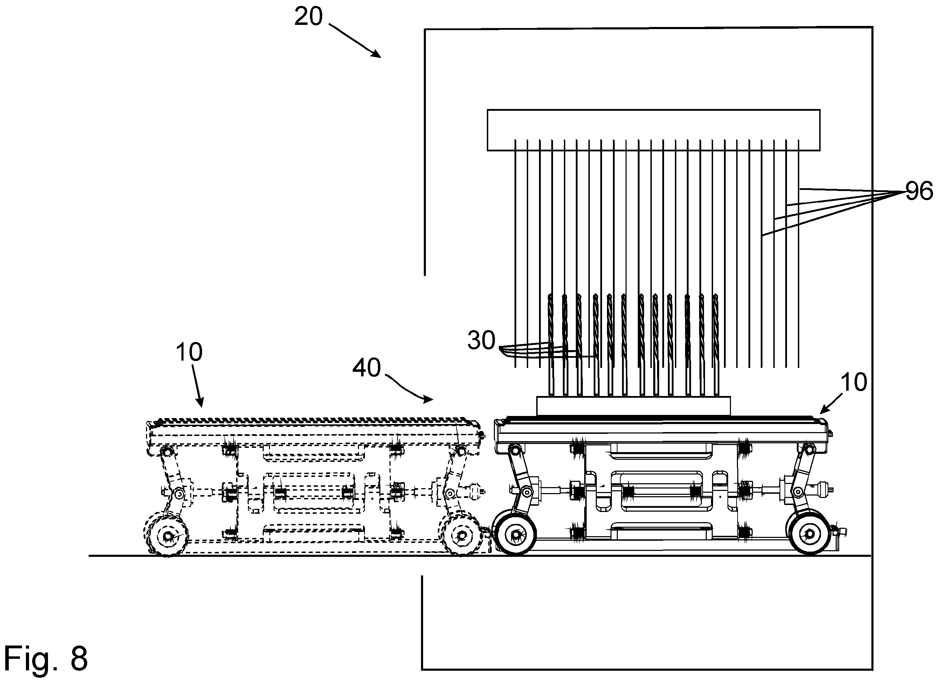

Fig. 7 und 8 zeigen schematisch, wie die Haltevorrichtung 10 in einer Beschichtungsanlage 20 verwendet werden kann.

Die Beschichtungsanlage 20 ist für heißdrahtaktivierte CVD-Beschichtungsverfahren ausgelegt. Filamente 96 sind in zwei zueinander parallelen Ebenen angebracht und senkrecht auf die Ablage 72 ausgerichtet.

Fig. 7 zeigt eine Reihe von Werkstücken 30, die von der Haltevorrichtung 10 zwischen den beiden Ebenen aus Filamenten 96 gehalten werden. Die Führungsnuten 94 halten dabei einen Werkstückhalter mit den Werkstücken 30 fest in einer aufrechten Position. Durch die oben beschriebene Höhen- und Seitenverstellbarkeit können die Werkstücke 30 exakt so positioniert werden, dass sie genau zwischen den beiden Ebenen angeordnet und den lokal, durch die Filamente erzeugten Hochtemperaturen von beispielsweise 600°C ausgesetzt sind. Auf den anderen Ablageplatten 92 können sich ebenso Werkstücke befinden.

Um die Werkstücke 30 auf der Haltevorrichtung 10 anzubringen oder sie nach einem Beschichtungsprozess zu entnehmen, befindet sich die Haltevorrichtung 10 in einer Bestückungsstellung und wird dazu auf einer herausziehbaren Unterlage aus der Beschichtungsanalage 20 herausgerollt. Zum Beschichten der Werkstücke 30 wird die Haltevorrichtung 10 vollständig in das Innere der Beschichtungsanlage 20 gerollt und befindet sich in einer Beschichtungsstellung. Zudem wird die herausziehbare Unterlage eingeschoben. Durch die Anordnung der Stützelemente 22, 48 und die Vorspannung der gelenkigen Verbindungen erfolgt ein Wechsel zwischen der Bestückungs- und der Beschichtungsstellung mit spielarmen Bewegungen.

Der Schutzbereich des europäischen Patents wird durch die Patentansprüche bestimmt.

### Bezugszeichenliste

- 10: Haltevorrichtung
- 12: Unterkonstruktion
- 14: Bodenplatte
- 16: Rolle
- 18a, b: Befestigungsblöcke
- 20: Beschichtungsanlage
- 22: 1. Stützelement
- 24: Längsstützeinheit
- 26: Längsschenkelelement
- 28a: Gabelfortsätze des 1. Stützelements
- 28b: Gabelfortsätze des 2. Stützelements
- 30: Werkstück
- 32a: Einzelfortsatz des 1. Stützelements
- 32b: Einzelfortsatz des 2. Stützelements
- 34: Achselement
- 36: Längsbefestigungsachse
- 37: Axialspanneinheit
- 38: Axialfeder
- 42: Radialfeder
- 44: Konus
- 46: Arretierring
- 48: 2. Stützelement
- 52: Querstützeinheit
- 54: Stellelement
- 56: Querschenkelelement
- 58: Schraube
- 62: Querbefestigungsachse
- 64: Spindelgewinde
- 66: Gewindemutter
- 68: Kopplungselement
- 72: Ablage
- 74: Befestigungseinheit
- 76: Betätigungseinheit
- 78: Ablageeinheit
- 82: Befestigungsplatte
- 84: Aussparung in der Befestigungsplatte
- 86: Exzenterwelle
- 88: Exzenter
- 92: Ablageplatte
- 94: Führungsnut
- 96: Filament
- 98: Anschlusskasten
- X: Längsschwenkachse
- Y: Querschwenkachse

## Patentansprüche

1. Beschichtungsanlage, umfassend
- eine Prozesskammer mit zugeordneten Beschichtungsmitteln (96) zur Erzeugung einer Beschichtung auf einem Werkstück (30),
- eine Haltevorrichtung (10) zum Halten des Werkstücks in der Prozesskammer, umfassend
- eine Ablage (72) für die Werkstücke (30),
- ein höhenverstellbares erstes Stützelement (22) und ein höhenverstellbares zweites Stützelement (48) für die Ablage (72),
- wobei die Stützelemente (22, 48) jeweils zumindest ein erstes und ein zweites Schenkelelement (26, 56) umfassen,
- wobei das jeweils erste und das jeweils zweite Schenkelelement (26, 56) gegeneinander um eine Schwenkachse (X, Y) schwenkbar gekoppelt sind,
- und wobei die Schwenkachse (X) des ersten Stützelements (22) unter einem Winkel zu der Schwenkachse (Y) des zweiten Stützelements (48) angeordnet ist
- wobei die Haltevorrichtung (10) mindestens zwischen einer ersten und einer zweiten Stellung verstellbar angeordnet ist, wobei die Haltevorrichtung (10) in der ersten Stellung innerhalb der Prozesskammer und in der zweiten Stellung mindestens teilweise außerhalb der Prozesskammer angeordnet ist.

2. Beschichtungsanlage nach Anspruch 1, wobei
- das erste und/oder zweite Stützelement (22, 48) ein Stellelement (54) umfasst, welches dazu ausgelegt ist, das Stützelement (22, 48) in seiner Höhe zu verändern.

3. Beschichtungsanlage nach Anspruch 2, wobei
- das Stellelement (54) dazu ausgelegt ist, einen Schwenkwinkel zwischen dem ersten und zweiten Schenkelelement (26, 56) zu verändern.

4. Beschichtungsanlage nach einem der vorangehenden Ansprüche, wobei
- das erste und/oder zweite Stützelement (22, 48) mindestens ein Axialfederelement (38) zum Aufbringen einer Kraftwirkung in Richtung seiner Schwenkachse (X, Y) umfasst.

5. Beschichtungsanlage nach Anspruch 4, wobei
- ein Konuselement (44) um die Schwenkachse (X, Y) herum angeordnet ist,
- wobei das Axialfederelement (38) auf das Konuselement (44) wirkt.

6. Beschichtungsanlage nach einem der vorangehenden Ansprüche, wobei
- ein Achselement (34, 58) entlang der Schwenkachse angeordnet ist,
- und wobei ein Radialfederelement (42) zwischen dem ersten und/oder zweiten Schenkelelement (26, 56) und dem Achselement (34, 58) radial wirkend angeordnet ist.

7. Beschichtungsanlage nach einem der vorangehenden Ansprüche, wobei
- das erste Schenkelelemente (26, 56) gabelförmig mit einem ersten und einem zweiten Gabelarm (28a, 28b) ausgestaltet ist,
- und wobei das zweite Schenkelelement (26, 56) zwischen dem ersten und dem zweiten Gabelarm (28a, 28b) eingreifend mit dem ersten Schenkelelement (26, 56) gekoppelt ist.

8. Beschichtungsanlage nach einem der vorangehenden Ansprüche, wobei
- die Ablage (72) mindestens teilweise in einer Seitenrichtung quer zur Höhenrichtung seitenverstellbar ist.

9. Beschichtungsanlage nach einem der vorangehenden Ansprüche, wobei
- mindestens das erste und zweite Schenkelement (26, 56) des ersten und/oder zweiten Stützelements (22, 48) aus Graphit besteht.

10. Beschichtungsanlage nach einem der vorangehenden Ansprüche, wobei
- das erste und/oder zweite Stützelement (22, 48) neben dem ersten und zweiten Schenkelelement (26, 56) ein drittes und viertes Schenkelelement (26, 56) umfasst,
- wobei das dritte und vierte Schenkelelement (26, 56) gegeneinander um eine Schwenkachse (X, Y) schwenkbar gekoppelt sind,
- und wobei die Schwenkachse (X, Y) des dritten und vierten Schenkelelements (26, 56) parallel und im Abstand zu der Schwenkachse (X, Y) des ersten und zweiten Schenkelelements (26, 56) angeordnet ist.

11. Beschichtungsanlage nach einem der Ansprüche 1 - 10,
- wobei zum Verstellen zwischen der ersten und der zweiten Stellung die Haltevorrichtung (10) auf mindestens einer Rolle (16) verschiebbar gelagert ist,
- und wobei die Rolle (16) aus Graphit gefertigt ist.

12. Beschichtungsanlage nacheinem der Ansprüche 1 - 11,
- wobei die Beschichtungsmittel Filamente (96) umfassen,
- welche so in der Prozesskammer angeordnet sind,
- dass in der ersten Stellung die Höhe der Ablage (72) relativ zu den Filamenten (96) einstellbar ist.

13. Verfahren zum Beschichten eines Werkstücks, bei dem
- das zu beschichtende Werkstück (30) in einer Prozesskammer einer Beschichtungsanlage (20) nach einem der Ansprüche 1 - 12 angeordnet ist
- und mit einem Plasmaverfahren beschichtet wird.

## Claims

1. A coating system, comprising
- a process chamber having associated coating means (96) for producing a coating on a workpiece (30),
- a holding device (10) for holding the workpiece in the process chamber, comprising
- a platform (72) for the workpieces (30),
- a height-adjustable first support element (22) and a height-adjustable second support element (48) for the platform (72),
- wherein each of the support elements (22, 48) comprises at least one first and one second limb element (26, 56),
- wherein the respective first and the respective second limb element (26, 56) are coupled so as to be pivotable relative to one another about a pivot axis (X, Y),
- and wherein the pivot axis (X) of the first support element (22) is arranged at an angle to the pivot axis (Y) of the second support element (48)
- wherein the holding device (10) is arranged so as to be displaceable at least between a first and a second position and wherein the holding device (10) is arranged inside the process chamber in the first position and at least partially outside the process chamber in the second position.

2. Coating system according to claim 1, wherein
- the first and/or second support element (22, 48) comprises an adjustment element (54), which is designed to change the height of the support element (22, 48).

3. Coating system according to claim 2, wherein
- the adjustment element (54) is designed to change a pivot angle between the first and second limb element (26, 56).

4. Coating system according to one of the preceding claims, wherein
- the first and/or second support element (22, 48) comprises at least one axial spring element (38) for applying a force effect in the direction of its pivot axis (X, Y).

5. Coating system according to claim 4, wherein
- a cone element (44) is arranged around the pivot axis (X, Y),
- wherein the axial spring element (38) acts on the cone element (44).

6. Coating system according to one of the preceding claims, wherein
- a shaft element (34, 58) is arranged along the pivot axis,
- and wherein a radial spring element (42) is arranged so as to act radially between the first and/or second limb element (26, 56) and the shaft element (34, 58).

7. Coating system according to one of the preceding claims, wherein
- the first limb element (26, 56) is fork-shaped with a first and a second fork arm (28a, 28b),
- and wherein the second limb element (26, 56) is engaged between the first and the second fork arm (28a, 28b) so as to be coupled with the first limb element (26, 56).

8. Coating system according to one of the preceding claims, wherein
- the platform (72) is adjustable sideways at least in part in a sideways direction transversely to the vertical direction.

9. Coating system according to one of the preceding claims, wherein
- at least the first and second limb element (26, 56) of the first and/or second support element (22, 48) consists of graphite.

10. Coating system according to one of the preceding claims, wherein
- the first and/or second support element (22, 48) comprises a third and fourth limb element (26, 56) in addition to the first and second limb element (26, 56),
- wherein the third and fourth limb element (26, 56) are coupled so as to be pivotable relative to one another about a pivot axis (X, Y),
- and wherein the pivot axis (X, Y) of the third and fourth limb element (26, 56) is arranged in parallel with and at a distance from the pivot axis (X, Y) of the first and second limb element (26, 56).

11. Coating system according to one of the claims 1-10,
- wherein the holding device (10) is shiftably mounted on at least one roller (16) for the displacement between the first and the second position,
- and wherein the roller (16) is manufactured from graphite.

12. Coating system according to one of the claims 1-11,
- wherein the coating means comprise filaments (96),
- which are arranged in the process chamber
- such that the height of the platform (72) can be adjusted relative to the filaments (96) in the first position.

13. Method for coating a workpiece, wherein
- the workpiece (30) to be coated is arranged in a process chamber of a coating system (20) according to one of claims 1 - 12
- and is coated by a plasma method.

## Revendications

1. Installation de revêtement comprenant
- une chambre de traitement à laquelle sont associés des moyens de revêtement (96) pour produire un revêtement sur une pièce à traveiller (30),
- un dispositif de maintien (10) pour maintenir la pièce dans la chambre de traitement, comprenant
- un plateau (72) pour les pièces à traveiller (30),
- un premier élément de support réglable en hauteur (22) et un deuxième élément de support réglable en hauteur (48) pour le plateau (72) ,
- dans lequel chacun des éléments de support (22, 48) comprend au moins un premier et un second élément de branche (26, 56),
- dans lequel le premier et le second élément de branche (26, 56) sont couplés de manière à pouvoir pivoter l'un par rapport à l'autre autour d'un axe de pivotement (X, Y),
- et dans lequel l'axe de pivotement (X) du premier élément de support (22) est disposé à un angle par rapport à l'axe de pivotement (Y) du second élément de support (48)
- dans lequel le dispositif de maintien (10) est disposé de manière à pouvoir être déplacé au moins entre une première et une deuxième position et dans lequel le dispositif de maintien (10) est disposé à l'intérieur de la chambre de traitement dans la première position et au moins partiellement à l'extérieur de la chambre de traitement dans la deuxième position.

2. Installation de revêtement selon la revendication 1, dans lequel
- le premier et/ou le deuxième élément de support (22, 48) comprend un élément de réglage (54) conçu pour modifier la hauteur de l'élément de support (22, 48).

3. Installation de revêtement selon la revendication 2, dans lequel
- l'élément de réglage (54) est conçu pour modifier un angle de pivotement entre le premier et le second élément de branche (26, 56).

4. Installation de revêtement selon l'une des revendications précédentes, dans lequel
- le premier et/ou le deuxième élément de support (22, 48) comprend au moins un élément de ressort axial (38) pour appliquer un effet de force dans la direction de son axe de pivotement (X, Y).

5. Installation de revêtement selon la revendication 4, dans lequel
- un élément conique (44) est disposé autour de l'axe de pivotement (X, Y),
- dans lequel l'élément ressort axial (38) agit sur l'élément conique (44).

6. Installation de revêtement selon l'une des revendications précédentes, dans lequel
- un élément d'axes (34, 58) est disposé le long de l'axe de pivotement,
- et dans lequel un élément de ressort radial (42) est disposé de manière à agir radialement entre le premier et/ou le second élément de branche (26, 56) et l'élément d'axes (34, 58).

7. Installation de revêtement selon l'une des revendications précédentes, dans lequel
- le premier élément de branche (26, 56) est en forme de fourche avec un premier et un second bras de fourche (28a, 28b),
- et dans lequel le second élément de branche (26, 56) est engagé entre le premier et le second bras de fourche (28a, 28b) de manière à être couplé avec le premier élément de branche (26, 56).

8. Installation de revêtement selon l'une des revendications précédentes, dans lequel
- le plateau (72) est réglable latéralement au moins en partie dans une direction latérale transversale à la direction verticale.

9. Installation de revêtement selon l'une des revendications précédentes, dans lequel
- au moins le premier et le deuxième élément de branche (26, 56) du premier et/ou du deuxième élément de support (22, 48) sont en graphite.

10. Installation de revêtement selon l'une des revendications précédentes , dans lequel
- le premier et/ou le deuxième élément de support (22, 48) comprend un troisième et un quatrième élément de branche (26, 56) en plus du premier et du deuxième élément de branche (26, 56),
- dans lequel le troisième et le quatrième élément de branche (26, 56) sont couplés de manière à pouvoir pivoter l'un par rapport à l'autre autour d'un axe de pivotement (X, Y),
- et dans lequel l'axe de pivotement (X, Y) du troisième et du quatrième élément de branche (26, 56) est disposé parallèlement à l'axe de pivotement (X, Y) du premier et du deuxième élément de branche (26, 56) et à une certaine distance de celui-ci.

11. Installation de revêtement selon l'une des revendications 1 à 10,
- dans lequel le dispositif de maintien (10) est monté de manière déplaçable sur au moins un rouleau (16) pour le déplacement entre la première et la deuxième position,
- et dans lequel le rouleau (16) est fabriqué en graphite.

12. Installation de revêtement selon l'une des revendications 1 à 11,
- dans lequel les moyens de revêtement comprennent des filaments (96),
- qui sont disposés dans la chambre de traitement
- de telle sorte que la hauteur du plateau (72) puisse être réglée par rapport aux filaments (96) dans la première position.

13. Procédé de revêtement d'une pièce, dans lequel
- la pièce à traveiller (30) à revêtir est disposée dans une chambre de traitement d'une installation de revêtement (20) selon l'une des revendications 1 à 12
- et est revêtue par une méthode plasma.
